# EUROPEAN PATENT APPLICATION

(11) **EP 4 823 292 A1**
(43) Date of publication of application: **14.10.2026**
(21) Application number: 26161207.1
(22) Date of filing: 27.02.2026
(51) Int. Cl.: H10H 29/80, H10H 20/831, H10H 20/813

(54) **DISPLAY APPARATUS AND METHOD OF MANUFACTURING THE SAME**

(30) Priority: 07.04.2025 KR 20250044900
(71) Applicant: Samsung Electronics Co., Ltd, Suwon-si, Gyeonggi-do 16677 (KR)
(72) Inventor: HWANG, Kyungwook, 16678 Suwon-si (KR); KIM, Joosung, 16678 Suwon-si (KR); SHIN, Dongchul, 16678 Suwon-si (KR); OH, Youngtek, 16678 Suwon-si (KR); HWANG, Junsik, 16678 Suwon-si (KR)
(74) Representative: Arnold & Siedsma

(57) **Abstract**

A display apparatus includes a display substrate including a plurality of pixel areas, and a plurality of light-emitting device chips on the display substrate and respectively corresponding to the plurality of pixel areas, each of the plurality of light-emitting device chips includes a stacked structure in which a first light-emitting structure, a second light-emitting structure, and a third light-emitting structure are stacked in a first direction on the display substrate, and the first light-emitting structure, the second light-emitting structure, and the third light-emitting structure are configured to generate light of different colors from each other.

## Description

### FIELD

The disclosure relates to a display apparatus and a method of manufacturing the same.

### BACKGROUND

Industrial demand for light-emitting diodes (LEDs) has been growing due to their advantages such as low power consumption and eco-friendliness. Recently, technologies for manufacturing high-resolution display apparatuses by using micro light-emitting devices have been used, and micro LED display apparatuses are widely used as next-generation display application that maximizes user experience. Accordingly, research regarding chip solutions which implement high luminance and high resolution by using micro-LEDs which are considered as the most excellent light source have been conducted.

A method of transferring a micro semiconductor chip, which has been manufactured separately, on a display substrate is mainly used to manufacture such micro-LED display apparatuses. In this regard, to implement colors, micro semiconductor chips respectively corresponding to red (R), green (G), and blue (B) colors may be first manufactured in difference processes and then may be bonded to a display substrate through a separate transferring process. Methods to improve efficiency of such manufacturing process have also been studied.

Information disclosed in this Background section has already been known to or derived by the inventors before or during the process of achieving the embodiments of the present application, or is technical information acquired in the process of achieving the embodiments. Therefore, it may contain information that does not form the prior art that is already known to the public.

### SUMMARY

Provided is a display apparatus including a light-emitting device chip and a method of manufacturing the display apparatus.

Additional aspects will be set forth in part in the description which follows and, in part, will be apparent from the description, or may be learned by practice of the presented embodiments of the disclosure.

According to an aspect of the disclosure, a display apparatus may include a display substrate including a plurality of pixel areas, and a plurality of light-emitting device chips on the display substrate and respectively corresponding to the plurality of pixel areas, each of the plurality of light-emitting device chips includes a stacked structure in which a first light-emitting structure, a second light-emitting structure, and a third light-emitting structure are stacked in a first direction on the display substrate, and the first light-emitting structure, the second light-emitting structure, and the third light-emitting structure are configured to generate light of different colors from each other. For example, each of the plurality of pixel areas may include three subpixel areas, and each of the plurality of light-emitting device chips is over the respective three subpixel areas.

Each of the first light-emitting structure, the second light-emitting structure, and the third light-emitting structure may include a p-type semiconductor layer, an active layer, and an n-type semiconductor layer and each of the plurality of light-emitting device chips may include a first n-electrode and a first p-electrode respectively contacting the n-type semiconductor layer of the first light-emitting structure and the p-type semiconductor layer of the first light-emitting structure, a second n-electrode and a second p-electrode respectively contacting the n-type semiconductor layer of the second light-emitting structure and the p-type semiconductor layer of the second light-emitting structure and a third n-electrode and a third p-electrode respectively contacting the n-type semiconductor layer of the third light-emitting structure and the p-type semiconductor layer of the third light-emitting structure.

The first light-emitting structure may be configured to generate red light, the second light-emitting structure is configured to generate green light and the third light-emitting structure is configured to generate blue light.

The second light-emitting structure may be stacked on the first light-emitting structure, and the third light-emitting structure is stacked on the second light-emitting structure.

The first n-electrode, the second n-electrode, the third n-electrode, the first p-electrode, the second p-electrode, and the third p-electrode may be exposed at a lower surface of the first light-emitting structure in the first direction.

The first n-electrode may include a conductive via extending from the lower surface of the first light-emitting structure, penetrating an inside of each of the plurality of light-emitting device chips and contacting the n-type semiconductor layer of the first light-emitting structure, the second n-electrode may include a conductive via extending from the lower surface of the first light-emitting structure, penetrating the inside of each of the plurality of light-emitting device chips and contacting the n-type semiconductor layer of the second light-emitting structure, and the third n-electrode may include a conductive via extending from the lower surface of the first light-emitting structure, penetrating the inside of each of the plurality of light-emitting device chips and contacting the n-type semiconductor layer of the third light-emitting structure.

The first n-electrode, the second n-electrode, and the third n-electrode may be connected to each other on the lower surface of the first light-emitting structure and form a common electrode.

The second p-electrode may include a conductive via extending from the lower surface of the first light-emitting structure, penetrating an inside of each of the plurality of light-emitting device chips and contacting the p-type semiconductor layer of the second light-emitting structure, and the third p-electrode may include a conductive via extending from the lower surface of the first light-emitting structure, penetrating the inside of each of the plurality of light-emitting device chips and contacting the p-type semiconductor layer of the third light-emitting structure.

Each of the plurality of light-emitting device chips may include a first surface facing the display substrate and a second surface opposite the first surface in the first direction, the first p-electrode, the second p-electrode, and the third p-electrode are exposed on the first surface and the first n-electrode, the second n-electrode, and the third n-electrode may be exposed on the second surface.

The first n-electrode may include a conductive via extending from the second surface, penetrating an inside of each of the plurality of light-emitting device chips and contacting the n-type semiconductor layer of the first light-emitting structure, the second n-electrode may include a conductive via extending from the second surface, penetrating the inside of each of the plurality of light-emitting device chips and contacting the n-type semiconductor layer of the second light-emitting structure, the second p-electrode may include a conductive via extending from the first surface, penetrating the inside of each of the plurality of light-emitting device chips and contacting the p-type semiconductor layer of the second light-emitting structure, the third p-electrode may include a conductive via extending from the first surface, penetrating the inside of each of the plurality of light-emitting device chips and contacting the p-type semiconductor layer of the third light-emitting structure.

The second light-emitting structure may be stacked on the third light-emitting structure, and the first light-emitting structure may be stacked on the second light-emitting structure.

The first n-electrode, the second n-electrode, the third n-electrode, the first p-electrode, the second p-electrode, and the third p-electrode may be exposed on a lower surface of the third light-emitting structure in the first direction.

The first n-electrode, the second n-electrode, the third n-electrode, the first p-electrode, the second p-electrode, and the third p-electrode may form a red light-emitting area, a green light-emitting area, and a blue light-emitting area on a surface that is perpendicular to the first direction.

The first n-electrode, the second n-electrode, the third n-electrode, the first p-electrode, the second p-electrode, and the third p-electrode may be configured such that the red light-emitting area is greatest in size among the red light-emitting area, the green light-emitting area, and the blue light-emitting area.

The first n-electrode, the second n-electrode, the third n-electrode, the first p-electrode, the second p-electrode, and the third p-electrode may be configured such that the red light-emitting area is greatest in size, and the blue light-emitting area is smallest in size among the red light-emitting area, the green light-emitting area, and the blue light-emitting area.

The blue light-emitting area may be spaced apart from the green light-emitting area in a second direction, and the blue light-emitting area may be spaced apart from the red light-emitting area in a third direction that is different from the second direction.

According to an aspect of the disclosure, a method of manufacturing a display apparatus may include forming an epitaxy structure by sequentially stacking, on a growth substrate, a third light-emitting structure, a second light-emitting structure, and a first light-emitting structure, each of the third light-emitting structure, the second light-emitting structure, and the first light-emitting structure including a p-type semiconductor layer, an active layer, and an n-type semiconductor layer and each of the third light-emitting structure, the second light-emitting structure, and the first light-emitting structure being configured to generate light of different wavelengths from each other, forming a light-emitting device chip by forming n-electrodes respectively contacting the n-type semiconductor layers of the first light-emitting structure, the second light-emitting structure, and the third light-emitting structure and forming p-electrodes respectively contacting the p-type semiconductor layers of the first light-emitting structure, the second light-emitting structure, and the third light-emitting structure, and transferring the light-emitting device chip on a display substrate.

The third light-emitting structure may be configured to generate blue light, the second light-emitting structure may be configured to generate green light, and the first light-emitting structure may be configured to generate red light.

The n-electrodes and the p-electrodes may be exposed on a same surface of the epitaxy structure.

The n-electrodes may be exposed on a first surface of the epitaxy structure and the p-electrodes may be exposed on a second surface of the epitaxy structure.

### BRIEF DESCRIPTION OF DRAWINGS

The above and other aspects, features, and advantages of certain embodiments of the disclosure will be more apparent from the following description taken in conjunction with the accompanying drawings, in which:
FIG. 1 is a plan view of a structure of a display apparatus according to an embodiment;
FIG. 2 is a plan view of a structure of a display apparatus according to a comparative example;
FIG. 3 is a cross-sectional view of a structure of a display apparatus according to an embodiment;
FIG. 4 is a cross-sectional view of a structure of a display apparatus according to an embodiment;
FIG. 5 is a cross-sectional view of a structure of a display apparatus according to an embodiment;
FIG. 6 is a plan view of a structure of a display apparatus according to an embodiment;
FIG. 7 is a plan view of a structure of a display apparatus according to an embodiment;
FIG. 8 is a plan view of a structure of a display apparatus according to an embodiment;
FIG. 9 is a block diagram of a display apparatus according to an embodiment;
FIG. 10 is a flowchart illustrating a method of manufacturing a display apparatus according to an embodiment;
FIGS. 11A, 11B, 11C, 11D, 11E and 11F are diagrams illustrating a method of manufacturing a display apparatus according to an embodiment;
FIG. 12 is a block diagram illustrating an example of an electronic apparatus including a display according to an embodiment;
FIG. 13 is a diagram illustrating an example of a mobile apparatus as an application example of an electronic apparatus, according to an embodiment;
FIG. 14 is a diagram illustrating an example of a head-up display apparatus for vehicles as an application example of an electronic apparatus, according to an embodiment;
FIG. 15 is a diagram illustrating an example of augmented reality glasses or virtual reality glasses as an application example of an electronic apparatus, according to an embodiment;
FIG. 16 is a diagram illustrating an example of a large-scale signage as an application example of an electronic apparatus, according to an embodiment; and
FIG. 17 is a diagram illustrating an example of a wearable display as an application example of an electronic apparatus, according to an embodiment.

### DETAILED DESCRIPTION

Reference will now be made in detail to embodiments, examples of which are illustrated in the accompanying drawings, wherein like reference numerals refer to like elements throughout. **In** this regard, the present embodiments may have different forms and should not be construed as being limited to the descriptions set forth herein. Accordingly, the embodiments are merely described below, by referring to the figures, to explain aspects. As used herein, the term "and/or" includes any and all combinations of one or more of the associated listed items. Expressions such as "at least one of," when preceding a list of elements, modify the entire list of elements and do not modify the individual elements of the list. For example, the expression, "at least one of a, b, and c," should be understood as including only a, only b, only c, both a and b, both a and c, both b and c, or all of a, b, and c.

Embodiments will now be described more fully with reference to the accompanying drawings. Embodiments are simply provided as an example, and thus, may be embodied in many different forms. **In** the drawings, like reference numerals in the drawings denote like elements, and sizes of components in the drawings may be exaggerated for clarity and convenience of explanation.

Throughout the drawings and the detailed description, unless otherwise described or provided, the same drawing reference numerals will be understood to refer to the same elements, features, and structures. The drawings may not be to scale, and the relative size, proportions, and depiction of elements in the drawings may be exaggerated for clarity, illustration, and convenience.

**In** the following description, when a component is referred to as being "above" or "on" another component, it may be directly on an upper, lower, left, or right side of the other component while making contact with the other component or may be above an upper, lower, left, or right side of the other component without making contact with the other component.

While such terms as "first," "second," etc., may be used to describe various components, the above terms are used only to distinguish one component from another. These terms are not intended to define that materials or structures of components are different.

An expression used in the singular encompasses the expression of the plural, unless it has a clearly different meaning in the context. When a portion "includes" a component, another component may be further included, rather than excluding the existence of the other component, unless otherwise described.

Moreover, the terms "part," "module," etc. refer to a unit processing at least one function or operation, and may be implemented by a hardware, a software, or a combination thereof.

The use of the terms "a" and "an" and "the" and similar referents in the context of describing embodiments (especially in the context of the following claims) are to be construed to cover both the singular and the plural.

Also, the steps of all methods described herein can be performed in any suitable order unless otherwise indicated herein or otherwise clearly contradicted by context. The use of any and all exemplary language (e.g., "such as") provided herein, is intended merely to better illuminate technical ideas and does not pose a limitation on the scope of embodiments unless otherwise claimed.

It will be understood that when an element or layer is referred to as being "over," "above," "on," "below," "under," "beneath," "connected to" or "coupled to" another element or layer, it can be directly over, above, on, below, under, beneath, connected or coupled to the other element or layer or intervening elements or layers may be present. **In** contrast, when an element is referred to as being "directly over," "directly above," "directly on," "directly below," "directly under," "directly beneath," "directly connected to" or "directly coupled to" another element or layer, there are no intervening elements or layers present.

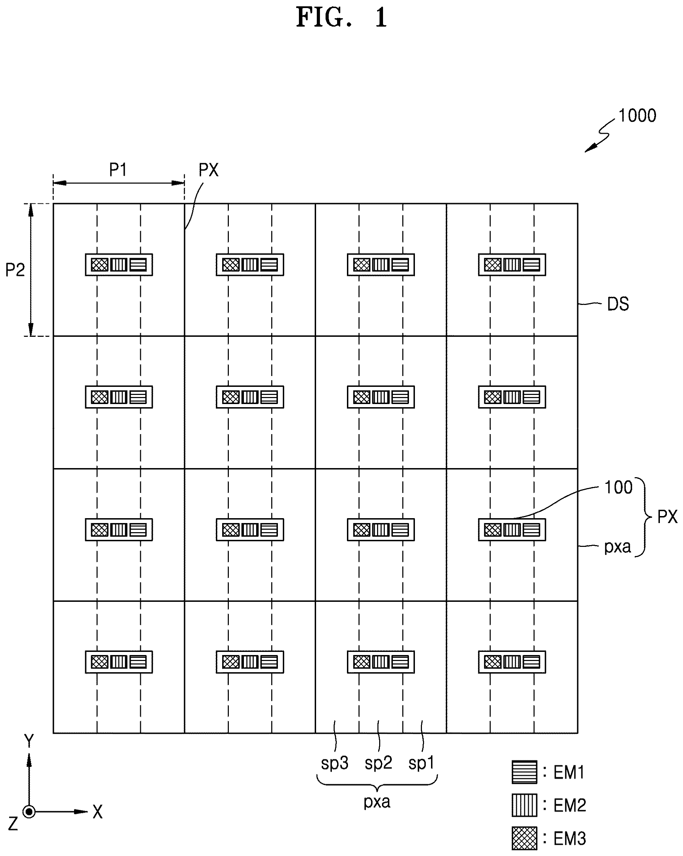

FIG. 1 is a plan view of a structure of a display apparatus according to an embodiment.

A display apparatus 1000 may include a display substrate DS including a plurality of pixel areas pxa and a plurality of light-emitting device chips 100 arranged on the display substrate DS. The light-emitting device chips 100 and the pixel areas pxa may respectively correspond to each other to define one pixel PX. That is, one light-emitting device chip 100 may be arranged in one pixel area pxa, thereby defining one pixel PX providing red light, green light, blue light, or combined light thereof.

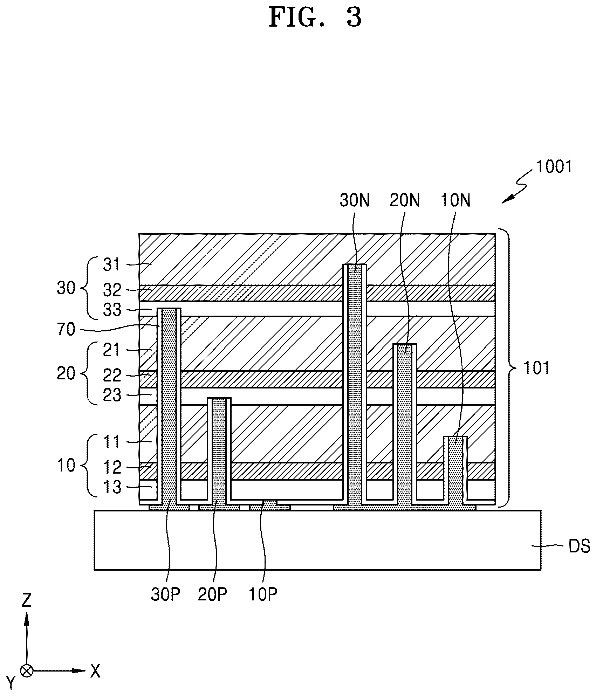

The light-emitting device chip 100 may be a stacked structure and may include a first light-emitting structure, a second light-emitting structure, and a third light-emitting structure which are stacked in a vertical direction (e.g., a direction away from the display substrate DS (Z direction)) and emit light of different colors from each other. The first light-emitting structure, the second light-emitting structure, and the third light-emitting structure may be on-off controlled individually in a monolithic structure. A specific example of a structure of the light-emitting device chip 100 is described in relation to FIG. 3.

The light-emitting device chip 100 may have an integrated structure in which structures emitting light of different wavelengths from each other are vertically stacked and may form, in a horizontal direction (e.g., in a surface perpendicular to a stacking direction), a first light-emitting area EM1, a second light-emitting area EM2, and a third light-emitting area EM3 which provide light of different colors from each other. For example, the first light-emitting area EM1 may emit red light, the second light-emitting area EM2 may emit green light, and the third light-emitting area EM3 may emit blue light. The first light-emitting area EM1, the second light-emitting area EM2, and the third light-emitting area EM3 may also be referred to as red light emitting area EM1, green light-emitting area EM2, and blue light emitting area EM3, respectively. The first light-emitting area EM1, the second light-emitting area EM2, and the third light-emitting area EM3 may be formed according to on/off of the first light-emitting structure, the second light-emitting structure, and the third light-emitting structure in the monolithic structure. **In** this perspective, it is described conceptually that the pixel area pxa in which the light-emitting device chip 100 is arranged may include three subpixel areas sp1, sp2, and sp3; however, this does not necessarily indicate that the colors are shown in a divided manner illustrated in the drawings. In addition, the size or the order of arrangement of the first light-emitting area EM1, the second light-emitting area EM2, and the third light-emitting area EM3 are an example and embodiments are not limited thereto. The size or the arrangement of the first light-emitting area EM1, the second light-emitting area EM2, and the third light-emitting area EM3 may be implemented in various ways according to efficiency per color and type of electrode driving each light-emitting area.

The light-emitting device chip 100 may be arranged at a central portion of the pixel area pxa over three subpixel areas sp1, sp2, and sp3.

With respect to a pixel pitch P1 in the X direction as indicated in FIG. 1 and a pixel pitch P2 in the Y direction as indicated in FIG. 1, the size of the light-emitting device chip 100, i.e., the lengths defining a two-dimensional (2D) arrangement in two directions in a surface in which the pixel PX is arranged in 2D manner, may be less than P1 and P2, respectively. That is, the pixel pitch P1 may be larger in length than the length of the light-emitting device chip 100 in the X direction, and the pixel pitch P2 may be larger in length than the length of the light-emitting device chip 100 in the Y direction. P1 and P2 may be identical to or different from each other. The light-emitting device chip 100 may have, for example, the length of about 5 um to about 100 um. The resolution of the display apparatus 1000 may vary according to an application to which the display apparatus 1000 is applied and may be, for example, about 5 PPI to about 1,000 PPI.

The area ratio occupied by the light-emitting device chip 100 in the pixel area pxa may be 50 % or less, 40 % or less, 30 % or less, 20 % or less, or 10 % or less.

As the light-emitting device chip 100 is configured to provide light of different colors controlled independently, with one epitaxy structure, a manufacturing process of transferring the light-emitting device chip 100 on the display substrate DS after manufacturing the light-emitting device chip 100 may be simplified significantly.

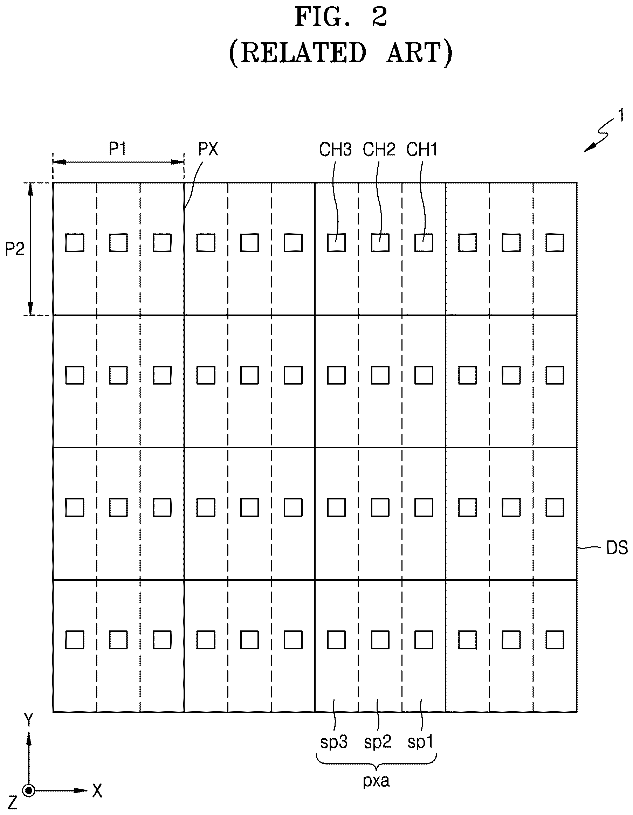

FIG. 2 is a plan view of a structure of a display apparatus according to a comparative example.

Referring to FIG. 2, a plurality of pixels PX of a display apparatus 1 may include a first light-emitting chip CH1, a second light-emitting chip CH2, and a third light-emitting chip CH3 which provide light of different colors from each other. The first light-emitting chip CH1, the second light-emitting chip CH2, and the third light-emitting chip CH3 may respectively provide red light, green light, and blue light and may respectively be arranged on subpixel areas sp1, sp2, and sp3. The first light-emitting chip CH1, the second light-emitting chip CH2, and the third light-emitting chip CH3 may be formed separately based on different epitaxy structures and may be transferred on the display substrate DS through three different processes. The manufacturing process of such display apparatus 1 may be more complex, compared to that of the display apparatus 1000 according to an embodiment, and it may be more difficult to increase the resolution of the display apparatus 1.

FIG. 3 is a cross-sectional view of a structure of a display apparatus according to an embodiment.

A display apparatus 1001 may include the display substrate DS and a light-emitting device chip 101 arranged on the display substrate DS. In FIG. 3, one light-emitting device chip 101 is described for convenience, and on the display substrate DS, a plurality of light-emitting device chips 101 may be arranged as illustrated in FIG. 1.

The display substrate DS may include at least some of circuit elements for driving the light-emitting device chip 101. The display substrate DS may include, for example, a plurality of transistors, various driving lines, etc.

The light-emitting device chip 101 may include a first light-emitting structure 10, a second light-emitting structure 20, and a third light-emitting structure 30 which are sequentially stacked on the display substrate DS and are configured to provide light of different colors from each other. Hereinafter, the first light-emitting structure 10, the second light-emitting structure 20, and the third light-emitting structure 30 which are sequentially stacked may be collectively referred to as an epitaxy structure. Such epitaxy structure may be formed in an integrated shape according to a series of sequential processes. This indicates that, in some embodiments, the epitaxy structure is not formed by combining structures formed separately in different processes through bonding, etc. In the Z direction, the first light-emitting structure 10 may be located at a lowermost portion of the epitaxy structure, the second light-emitting structure 20 may be stacked on the first light-emitting structure 10, and the third light-emitting structure 30 may be stacked on the second light-emitting structure 20. The first light-emitting structure 10 may generate light of red wavelength band, the second light-emitting structure 20 may generate light of green wavelength band, and the third light-emitting structure 30 may generate light of blue wavelength band.

The first light-emitting structure 10, the second light-emitting structure 20, and the third light-emitting structure 30 may include group III-V nitride semiconductor materials. The group III-V nitride semiconductor materials may include, for example, GaN, InGaN, AlInGaN, AlGaInp, etc. For example, in an embodiment, a GaN-based semiconductor material may be used.

Each of the first to third light-emitting structures 10, 20, and 30 may include a p-type semiconductor layer, an active layer, and an n-type semiconductor layer which are stacked. For example, each of the first to third light-emitting structures 10, 20, and 30 may have a structure in which the p-type semiconductor layer, the active layer, and the n-type semiconductor layer are sequentially stacked in a stacking direction.

The first light-emitting structure 10 may include a p-type semiconductor layer 13, an active layer 12 having a quantum well structure, and an n-type semiconductor layer 11 which are sequentially stacked in a stacking direction (Z direction). The p-type semiconductor layer 13 may be a semiconductor layer doped with a p-type impurity, for example, a p-GaN layer. Mg, Zn, Be, etc. may be used as the p-type impurity. The active layer 12 may be a layer emitting light by electron-hole recombination. The active layer 12 may be grown and formed on the p-type semiconductor layer 13. The active layer 12 may have a quantum well structure. For example, the active layer 12 may have a structure of a single quantum well or a multi quantum well made by periodically changing values of x, y and z in AlₓGa_{y}In_{z}N and adjusting a bandgap. For example, a quantum well layer and a barrier layer may be formed in pair, e.g., InGaN/GaN, InGaN/InGaN, InGaN/AlGaN, or InGaN/InAlGaN, to form the quantum well structure, and bandgap energy may be controlled according to an indium (In) composition ratio of a material layer including In to adjust an emission wavelength band. The n-type semiconductor layer 11 may be formed on the active layer 12. The n-type semiconductor layer 11 may be a semiconductor layer doped with an n-type impurity, for example, an n-GaN layer. Si, Ge, Se, Te, etc. may be used as the n-type impurity.

The second light-emitting structure 20 may include a p-type semiconductor layer 23, an active layer 22 having a quantum well structure, and an n-type semiconductor layer 21 which are sequentially stacked. The description regarding the materials of the p-type semiconductor layer 13, the active layer 12, and the n-type semiconductor layer 11 of the first light-emitting structure 10 may be applied to the p-type semiconductor layer 23, the active layer 22, and the n-type semiconductor layer 21 of the second light-emitting structure 20. Specific configurations of the active layer 22 may be different from that of the active layer 12, and an indium composition ratio thereof may be adjusted according to an emission wavelength band.

The third light-emitting structure 30 may include a p-type semiconductor layer 33, an active layer 32 having a quantum well structure, and an n-type semiconductor layer 31 which are sequentially stacked. The description of the p-type semiconductor layer 13, the active layer 12, and the n-type semiconductor layer 11 of the first light-emitting structure 10 may be applied to the p-type semiconductor layer 33, the active layer 32, and the n-type semiconductor layer 31 of the third light-emitting structure 30. Specific configurations of the active layer 32 may be different from those of the active layer 12 and the active layer 22, and an indium composition ratio thereof may be adjusted according to an emission wavelength band.

The bandgap energy may be controlled according to the In composition ratio of the material layer including In in each of the active layers 12, 22, and 32 of the first to third light-emitting structures 10, 20, and 30, thereby determining the emission wavelength band. The higher the In content is, the greater the emission wavelength band may be. The In content of the active layer 12 of the first light-emitting structure 10 generating light of red wavelength band may be greater than the In content of the active layer 22 of the second light-emitting structure 20 generating light of green wavelength band and the In content of the active layer 32 of the third light-emitting structure 30 generating light of blue wavelength band, and the In content of the active layer 22 of the second light-emitting structure 20 generating light of green wavelength band may be greater than the In content of the active layer 32 of the third light-emitting structure 30 generating light of blue wavelength band.

The light-emitting device chips 101 may include electrodes for driving the first light-emitting structure 10, the second light-emitting structure 20, and the third light-emitting structure 30. The electrodes may include a first n-electrode 10N and a first p-electrode 10P respectively contacting the n-type semiconductor layer 11 and the p-type semiconductor layer 13 of the first light-emitting structure 10, a second n-electrode 20N and a second p-electrode 20P respectively contacting the n-type semiconductor layer 21 and the p-type semiconductor layer 23 of the second light-emitting structure 20, and a third n-electrode 30N and a third p-electrode 30P respectively contacting the n-type semiconductor layer 31 and the p-type semiconductor layer 33 of the third light-emitting structure 30.

At least some of the first n-electrode 10N, the second n-electrode 20N, the third n-electrode 30N, the first p-electrode 10P, the second p-electrode 20P, and the third p-electrode 30P of the light-emitting device chip 101 may have a shape of a conductive via penetrating the light-emitting device chip 101.

In a display apparatus 1001, the first n-electrode 10N, the second n-electrode 20N, the third n-electrode 30N, the first p-electrode 10P, the second p-electrode 20P, and the third p-electrode 30P of the light-emitting device chip 101 may all be exposed on the same surface of the light-emitting device chip 101. As illustrated in FIG. 3, the first n-electrode 10N, the second n-electrode 20N, the third n-electrode 30N, the first p-electrode 10P, the second p-electrode 20P, and the third p-electrode 30P may be exposed on the lower surface of the light-emitting device chip 101 (i.e., a surface of the light-emitting device chip 101 facing the display substrate DS) and may be bonded to the display substrate DS. The surface may be referred to as the lower surface of the first light-emitting structure 10. The first to third n-electrodes 10N, 20N, and 30N may each have a shape of a conductive via and may respectively be in electric contact with the n-type semiconductor layers 11, 21, and 31 of the first to third light-emitting structures 10, 20, and 30.

The first n-electrode 10N may have a shape of a conductive via extending from one surface of the light-emitting device chip 101 (i.e., the lower surface of the first light-emitting structure 10) to pass through the inside of the light-emitting device chip 101 and contact the n-type semiconductor layer 11 of the first light-emitting structure 10. The first n-electrode 10N may pass through the p-type semiconductor layer 13 and the active layer 12 of the first light-emitting structure 10 and may contact the n-type semiconductor layer 11. The first n-electrode 10N may terminate in the n-type semiconductor layer 11 of the first light-emitting structure 10. The second n-electrode 20N may have a shape of a conductive via extending from the lower surface of the first light-emitting structure 10 to pass through the inside of the light-emitting device chip 101 and contact the n-type semiconductor layer 21 of the second light-emitting structure 20. The second n-electrode 20N may pass through the first light-emitting structure 10 and pass through the p-type semiconductor layer 23 and the active layer 22 of the second light-emitting structure 20 to contact the n-type semiconductor layer 21 of the second light-emitting structure 20. The second n-electrode 20N may terminate in the n-type semiconductor layer 21 of the second light-emitting structure 20. The third n-electrode 30N may have a shape of a conductive via extending from the lower surface of the first light-emitting structure 10 to pass through the inside of the light-emitting device chip 101 and to contact the n-type semiconductor layer 31 of the third light-emitting structure 30. The third n-electrode 30N may pass through the first light-emitting structure 10 and the second light-emitting structure 20 and pass through the p-type semiconductor layer 33 and the active layer 32 of the third light-emitting structure 30 to contact the n-type semiconductor layer 31 of the third light-emitting structure 30. The third n-electrode 30N may terminate in the n-type semiconductor layer 31 of the third light-emitting structure 30. The first to third n-electrodes 10N, 20N, and 30N may be connected to each other on one surface of the light-emitting device chip 101 to form an n-common electrode.

The second and third p-electrodes 20P and 30P may each have a shape of a conductive via and may respectively electrically contact with the p-type semiconductor layers 23 and 33 of the second and third light-emitting structures 20 and 30. The second p-electrode 20P may have a shape of a conductive via extending from one surface of the light-emitting device chip 101 (i.e., the lower surface of the first light-emitting structure 10) to pass through the inside of the light-emitting device chip 101 and contact the p-type semiconductor layer 23 of the second light-emitting structure 20. The first p-electrode 10P may terminate in the p-type semiconductor layer 13 of the first light-emitting structure 10. The second p-electrode 20P may pass through the first light-emitting structure 10 to contact the p-type semiconductor layer 23 of the second light-emitting structure 20. The second p-electrode 20P may terminate in the p-type semiconductor layer 23 of the second light-emitting structure 20. The third p-electrode 30P may have a shape of a conductive via extending from the lower surface of the first light-emitting structure 10 to pass through the inside of the light-emitting device chip 101 and contact the p-type semiconductor layer 33 of the third light-emitting structure 30. The third p-electrode 30P may terminate in the p-type semiconductor layer 33 of the third light-emitting structure 30. The third p-electrode 30P may pass through the first light-emitting structure 10 and the second light-emitting structure 20 to contact the p-type semiconductor layer 33 of the third light-emitting structure 30.

A passivation layer 70 may be formed to extend from an inner side surface of the conductive vias to one surface of the light-emitting device chip 101 facing the display substrate DS (i.e., the lower surface of the first light-emitting structure 10). The passivation layer 70 may include various dielectric materials. The dielectric material may include, for example, SiO₂, TiO₂, Si₃N₄, AlOₓ, AlOxNy, Ta₂O₅, TiN, AlN, ZrO₂, TiAlN, TiSiN, HfOx, or various combinations thereof.

The first to third n-electrodes 10N, 20N, and 30N and the first to third p-electrodes 10P, 20P, and 30P may include an electrode material. The electrode material may include, for example, Al, Ti, Pt, Ag, Au, Pd, TiW, or various combinations thereof. The electrode material may include a transparent electrode material, for example, ITO.

The display apparatus 1001 may have a structure in which four electrodes for driving the light-emitting device chip 101 (i.e., three p-electrodes and one n-common electrode) are arranged on the lower surface of the first light-emitting structure 10, which is a lower surface of the light-emitting device chip 101.

As described above, the first to third light-emitting structures 10, 20, and 30 may respectively emit red light, green light, and blue light, and such structure in which the first light-emitting structure 10 is located at the lowermost portion may have high process convenience. This is because, in general, according to a manufacturing process in which a light-emitting structure generating light of a short wavelength band is first formed on a growth substrate, a hole may be formed from the red light-emitting structure formed at the uppermost layer of the epitaxy structure (i.e., the first light-emitting structure 10) and then a conductive via process may be performed. However, there may be a disadvantage of reduced emission area as the first light-emitting structure 10 generating red light and having relatively low emission efficiency is located at the lowermost portion and penetrated by a plurality of conductive vias.

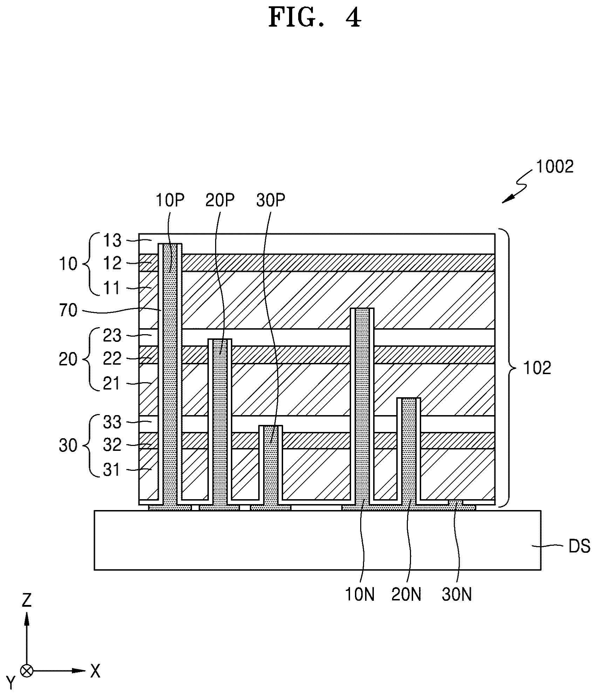

FIG. 4 is a cross-sectional view of a structure of a display apparatus according to an embodiment.

A display apparatus 1002 may have a stacking order in which the third light-emitting structure 30, the second light-emitting structure 20, and the first light-emitting structure 10 are stacked on the display substrate DS, contrary to the display apparatus 1001 of FIG. 3.

One surface of a light-emitting device chip 102 facing the display substrate DS may be the lower surface of the third light-emitting structure 30, and the first n-electrode 10N, the second n-electrode 20N, the third n-electrode 30N, the first p-electrode 10P, the second p-electrode 20P, and the third p-electrode 30P may be exposed on the lower surface of the third light-emitting structure 30 and may be bonded to the display substrate DS.

The first n-electrode 10N may have a shape of a conductive via extending from one surface of the light-emitting device chip 102 (i.e., the lower surface of the third light-emitting structure 30) to pass through the inside of the light-emitting device chip 102 and contact the n-type semiconductor layer 11 of the first light-emitting structure 10. The first n-electrode 10N may terminate in the n-type semiconductor layer 11 of the first light-emitting structure 10. The second n-electrode 20N may have a shape of a conductive via extending from the lower surface of the third light-emitting structure 30 to pass through the inside of the light-emitting device chip 102 and contact the n-type semiconductor layer 21 of the second light-emitting structure 20. The second n-electrode 10N may terminate in the n-type semiconductor layer 21 of the second light-emitting structure 20. The first to third n-electrodes 10N, 20N, and 30N may be connected to each other on the lower surface of the third light-emitting structure 30 to form an n-common electrode.

The first, second, and third p-electrodes 10P, 20P, and 30P may each have a shape of a conductive via and may respectively electrically contact with the p-type semiconductor layers 13, 23, and 33 of the first, second, and third light-emitting structures 10, 20, and 30. The first p-electrode 10P may have a shape of a conductive via extending from the lower surface of the third light-emitting structure 30 to pass through the inside of the light-emitting device chip 102 and contact the p-type semiconductor layer 13 of the first light-emitting structure 10. The first p-electrode 10P may terminate in the p-type semiconductor layer 13 of the first light-emitting structure 10. The second p-electrode 20P may have a shape of a conductive via extending from the lower surface of the third light-emitting structure 30 to pass through the inside of the light-emitting device chip 102 and contact the p-type semiconductor layer 23 of the second light-emitting structure 20. The second p-electrode 20P may terminate in the p-type semiconductor layer 23 of the second light-emitting structure 20. The third p-electrode 30P may have a shape of a conductive via extending from the lower surface of the third light-emitting structure 30 to pass through the inside of the light-emitting device chip 102 and contact the p-type semiconductor layer 33 of the third light-emitting structure 30. The third p-electrode 30P may terminate in the p-type semiconductor layer 33 of the third light-emitting structure 30.

The display apparatus 1002 may have a structure in which four electrodes for driving the light-emitting device chip 102 (i.e., three p-electrodes and one n-common electrode) are arranged on the lower surface of the third light-emitting structure 30, which is the lower surface of the light-emitting device chip 102.

As described above, the first to third light-emitting structures 10, 20, and 30 may respectively emit red light, green light, and blue light, and in such structure in which the third light-emitting structure 30 is located at the lowermost portion, and the first light-emitting structure 10 is located at the uppermost portion, there may be an advantage in efficiency of red light emission. In general, emission efficiency of red light may be lower than those of other colors. As the first light-emitting structure 10 generating red light is located at the uppermost portion, the number of conductive vias passing through the first light-emitting structure 10 may be minimized, and the loss of emission area may be reduced. To manufacturing such structure, according to a manufacturing process in which a light-emitting structure generating light of a short wavelength band is first formed on a growth substrate, after the growth substrate is removed, the conductive via process may be performed from the third light-emitting structure 30 that was located contact the growth substrate.

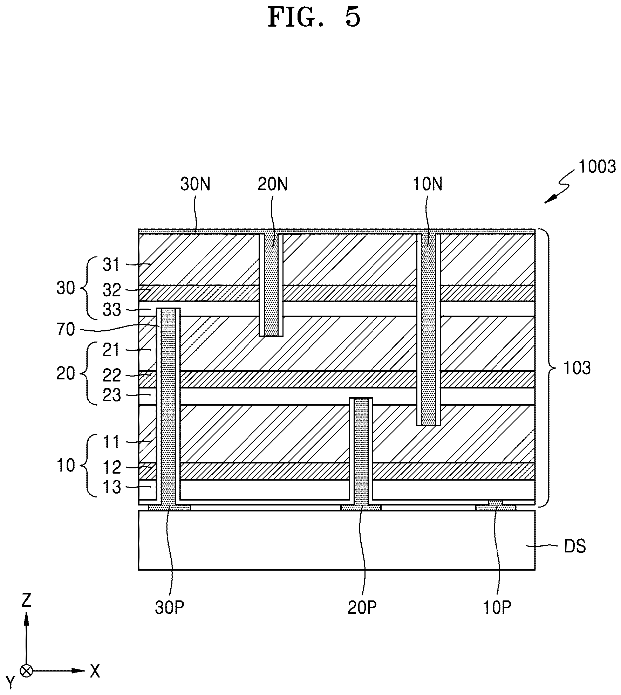

FIG. 5 is a cross-sectional view of a structure of a display apparatus according to an embodiment.

A display apparatus 1003 may have a stacking order in which the first light-emitting structure 10, the second light-emitting structure 20, and the third light-emitting structure 30 are stacked on the display substrate DS. The first p-electrode 10P, the second p-electrode 20P, and the third p-electrode 30P may be exposed on a lower surface of a light-emitting device chip 103 (i.e., the lower surface of the first light-emitting structure 10) and the first n-electrode 10N, the second n-electrode 20N, and the third n-electrode 30N may be exposed on an upper surface of the light-emitting device chip 103 (i.e., an upper surface of the third light-emitting structure 30).

The first n-electrode 10N may have a shape of a conductive via extending from the upper surface of the light-emitting device chip 103 to pass through the inside of the light-emitting device chip 103 and contact the n-type semiconductor layer 11 of the first light-emitting structure 10. The first n-electrode 10N may terminate in the n-type semiconductor layer 11 of the first light-emitting structure 10. The second n-electrode 20N may have a shape of a conductive via extending from the upper surface of the light-emitting device chip 103 to pass through the inside of the light-emitting device chip 103 and contact the n-type semiconductor layer 21 of the second light-emitting structure 20. The second n-electrode 20N may terminate in the n-type semiconductor layer 21 of the second light-emitting structure 20. The first n-electrode 10N, the second n-electrode 20N, and the third n-electrode 30N may be connected to each other on the upper surface of the light-emitting device chip 103 to form an n-common electrode.

The second p-electrode 20P may have a shape of a conductive via extending from the lower surface of the light-emitting device chip 103 to pass through the inside of the light-emitting device chip 103 and contact the p-type semiconductor layer 23 of the second light-emitting structure 20. The second p-electrode 20P may terminate in the p-type semiconductor layer 23 of the second light-emitting structure 20. The third p-electrode 30P may have a shape of a conductive via extending from the lower surface of the light-emitting device chip 103 to pass through the inside of the light-emitting device chip 103 and contact the p-type semiconductor layer 33of the third light-emitting structure 30. The third p-electrode 30P may terminate in the p-type semiconductor layer 33 of the third light-emitting structure 30.

The display apparatus 1003 may have a structure in which four electrodes for driving the light-emitting device chip 103, i.e., three p-electrodes and one n-common electrode are divided and arranged on both surfaces of the light-emitting device chip 103. Such structure may be selected as a structure which properly considers two aspects of process convenience and emission efficiency of red light described in relation to the display apparatus 1001 of FIG. 3 and the display apparatus 1002 of FIG. 4.

According to the arrangement of the first n-electrode 10N, the second n-electrode 20N, the third n-electrode 30N, the first p-electrode 10P, the second p-electrode 20P, and the third p-electrode 30P described in relation to FIGS. 3 to 5, for example, cross-sectional areas of the conductive vias and arrangement order of the electrodes, the shape of the emission areas of various colors implemented horizontally may be adjusted variously. The shape of the emission areas of various colors may be adjusted by a separation structure, etc. in addition to the arrangement of the electrodes.

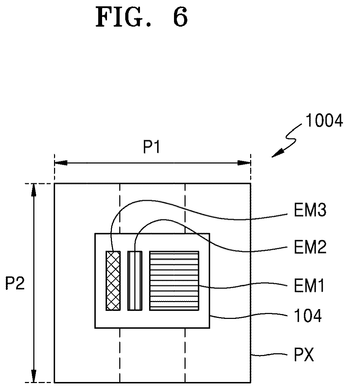

FIGS. 6 to 8 are plan views illustrating display apparatuses in which emission areas of each color are adjusted.

Referring to FIG. 6, one pixel PX of a display apparatus 1004 may include one light-emitting device chip 104. The light-emitting device chip 104 may have a structure in which light-emitting structures generating light of different wavelengths from each other are vertically stacked in an integrated manner as described above, and specific configuration thereof such as an electrode arrangement, etc. may be specifically set such that a red light-emitting area EM1 is the largest. In this embodiment, a blue light-emitting area EM3 and a green light-emitting area EM2 may have the same size. Each of EM1, EM2 and EM3 may have the same length in the direction of P2, but have different lengths in the direction of P1.

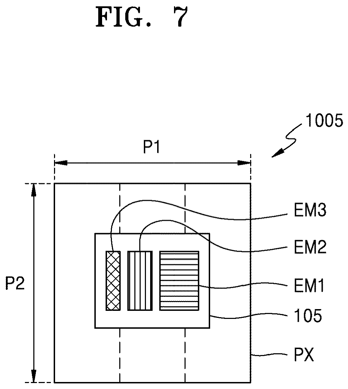

Referring to FIG. 7, one pixel PX of a display apparatus 1005 may include one light-emitting device chip 105. The light-emitting device chip 105 may have a structure in which light-emitting structures generating light of different wavelengths from each other are vertically stacked in an integrated manner as described above, and specific configuration thereof such as an electrode arrangement, etc. may be specifically set such that the red light-emitting area EM1 is the largest, and the blue light-emitting area EM3 is the smallest. Each of EM1, EM2 and EM3 may have the same length in the direction of P2, but have different lengths in the direction of P1.

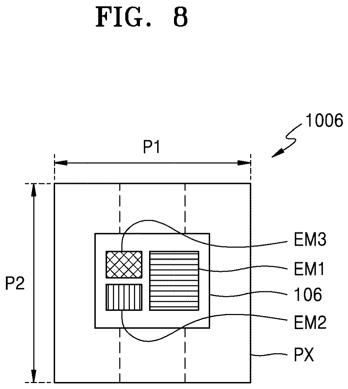

Referring to FIG. 8, one pixel PX of a display apparatus 1006 may include one light-emitting device chip 106. The light-emitting device chip 106 may have a structure in which light-emitting structures generating light of different wavelengths from each other are vertically stacked in an integrated manner as described above, and specific configuration thereof such as an electrode arrangement, etc. may be specifically set such that the red light-emitting area EM1 is the largest, and the blue light-emitting area EM3 and the green light-emitting area EM2 have the same size. A direction in which the blue light-emitting area EM3 and the green light-emitting area EM2 are spaced apart and a direction in which the blue light-emitting area EM3 and the red light-emitting area EM1 are spaced apart may be different from each other and may be perpendicular to each other as illustrated in the drawings.

The size of the red light-emitting area EM1, the green light-emitting area EM2, and the blue light-emitting area EM3 described in relation to FIGS. 6 to 8 are provided considering the possibility of low emission efficiency in the red light-emitting structure. In addition to this, the division of the emission areas may be properly set considering the stacking order of the red light-emitting structure, the blue light-emitting structure, and the green light-emitting structure described in relation to FIGS. 3 to 5.

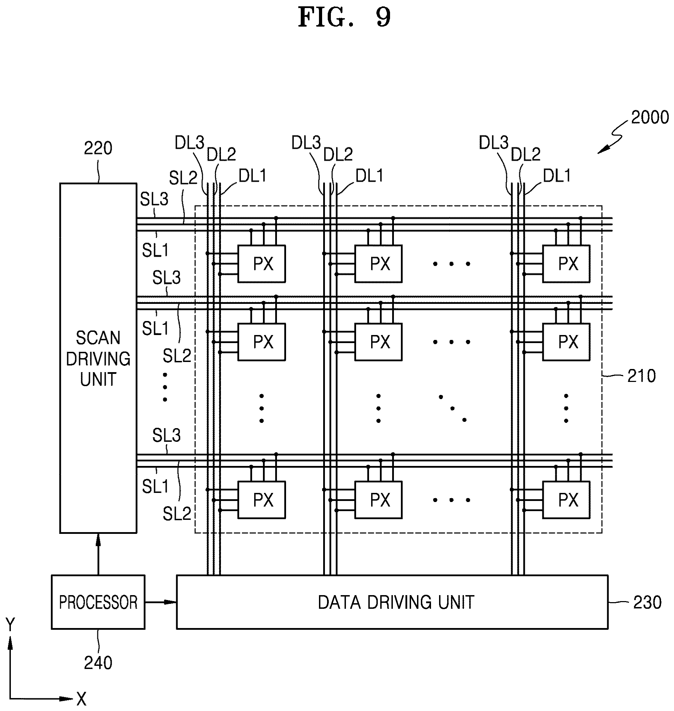

FIG. 9 is a block diagram of a display apparatus according to some embodiments. Referring to FIG. 9, a display apparatus 200 may include a pixel array 210, a scan driving unit 220, a data driving unit 230, and a processor 240. The pixel array 210 may include a plurality of pixels PX arranged in a 2D array, a plurality of scan line sets delivering a scan signal to the plurality of pixels PX, and a plurality of data line sets delivering a data signal to the plurality of pixels PX.

The display apparatus 200 may be one of the display apparatuses 1000 to 1006 described above, and each of the plurality of pixels PX of the pixel array 210 may include the light-emitting device chip (100 to 106) in which the first light-emitting structure 10 emitting red light, the second light-emitting structure 20 emitting green light, and the third light-emitting structure 30 emitting blue light are vertically stacked in a monolithic manner as described above. The first to third light-emitting structures 10, 20, and 30 may be electrically connected to first to third transistors, respectively. At least some of components such as transistors, driving lines, the scan driving unit 220, the data driving unit 230, the processor 240, etc. may be formed or arranged on the display substrate DS.

Each scan line set may include a first scan line SL1, a second scan line SL2, and a third scan line SL3 which extend in the X direction. The first scan line SL1, the second scan line SL2, and the third scan line SL3 may be connected to the plurality of pixels PX arranged in the X direction. For example, the first scan line SL1 may be electrically connected to a gate electrode of the first transistor in each pixel PX, the second scan line SL2 may be electrically connected to a gate electrode of the second transistor in each pixel PX, and the third scan line SL3 may be electrically connected to a gate electrode of the third transistor in each pixel PX. The first scan line SL1, the second scan line SL2, and the third scan line SL3 may also be connected to the scan driving unit 220 and receive a scan signal from the scan driving unit 220.

Each data line set may include a first data line DL1, a second data line DL2, and a third data line DL3 which extend in the Y direction. The first data line DL1, the second data line DL2, and the third data line DL3 may be connected to the plurality of pixels PX arranged in the Y direction. For example, the first data line DL1 may be electrically connected to a source horizontal line SHL of the first transistor in each pixel PX, the second data line DL2 may be electrically connected to a source horizontal line SHL of the second transistor in each pixel PX, and the third data line DL3 may be electrically connected to a source horizontal line SHL of the third transistor in each pixel PX. The first data line DL1, the second data line DL2, and the third data line DL3 may also be connected to the data driving unit 230 and receive a data signal from the data driving unit 230.

The processor 240 may control operations of the scan driving unit 220 and the data driving unit 230 based on data of an image to be displayed by the pixel array 210 to adjust a scan signal and a data signal provided to each pixel PX.

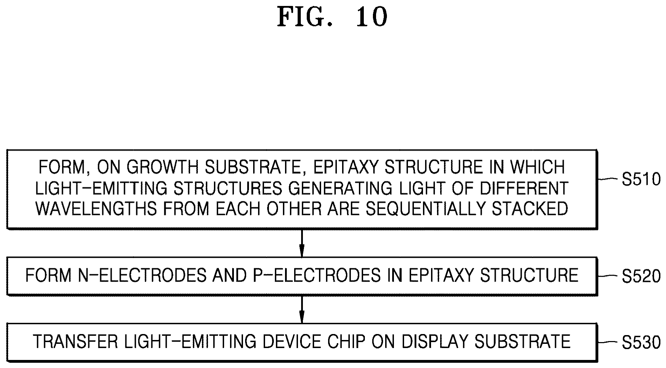

FIG. 10 is a flowchart illustrating a method of manufacturing a display apparatus according to some embodiments.

On a growth substrate, an epitaxy structure in which light-emitting structures generating light of different wavelengths from each other are sequentially stacked may be formed in operation S510. The light-emitting structures may each include a p-type semiconductor layer, an active layer, and an n-type semiconductor layer and may be configured to generate light of different wavelengths from each other.

Then, n-electrodes and p-electrodes are formed in the epitaxy structure in operation S520. The n-electrodes may respectively be contacting the n-type semiconductor layers of the light-emitting structures, and the p-electrodes may respectively be contacting the p-electrodes of the light-emitting structures. To form such electrodes, a process of forming at least one through hole inside the epitaxy structure, forming an insulating layer on a part of an inner wall of the through hole, and filling an electrode material therein may be performed. The n-electrodes and the p-electrodes may be formed to be exposed on one surface of the epitaxy structures or to be divided and exposed on both surfaces of the epitaxy structure. When it is necessary, the electrode process may be performed before removal of the growth substrate, or the electrode process may be performed on a surface of the epitaxy structure that contacts the growth substrate. Alternatively, a part of the electrode process may be performed on the growth substrate, and another part of the electrode process may be performed after the removal of the growth substrate.

Then, the light-emitting device chip in which the electrodes are formed in the epitaxy structure may be transferred to the display substrate in operation S530. The light-emitting device chip may respectively correspond to the pixels PX as illustrated in FIG. 1 and may be arranged at a central portion of the pixel area pxa. In the process of transferring the light-emitting device chip on the display substrate, for example, a method using a stamp, a method using a laser, a fluid self-alignment method, etc. may be used.

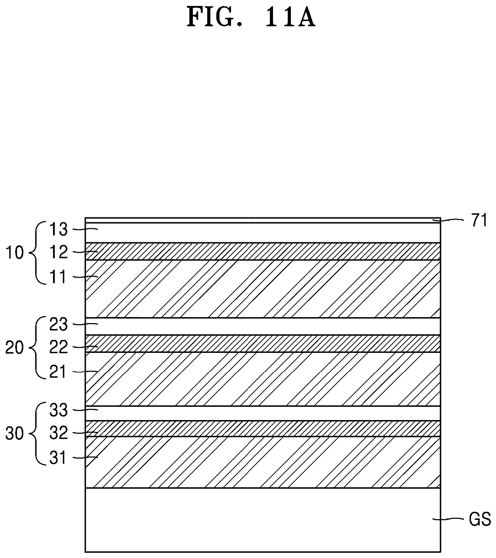

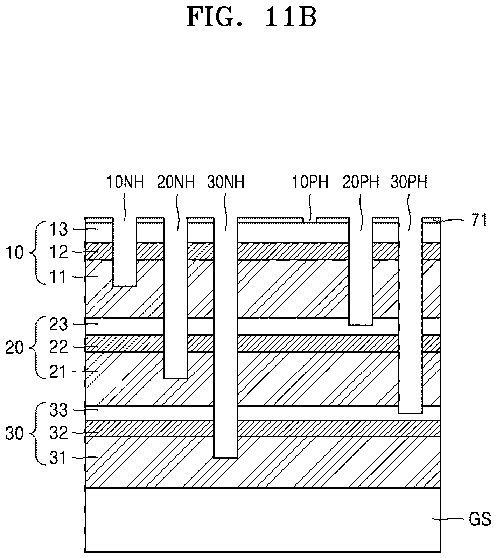

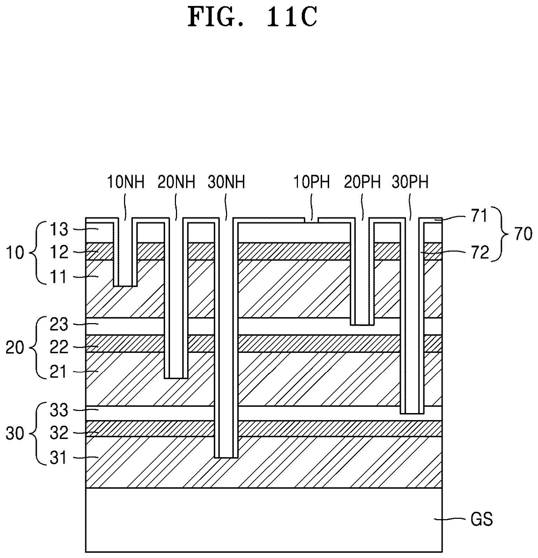

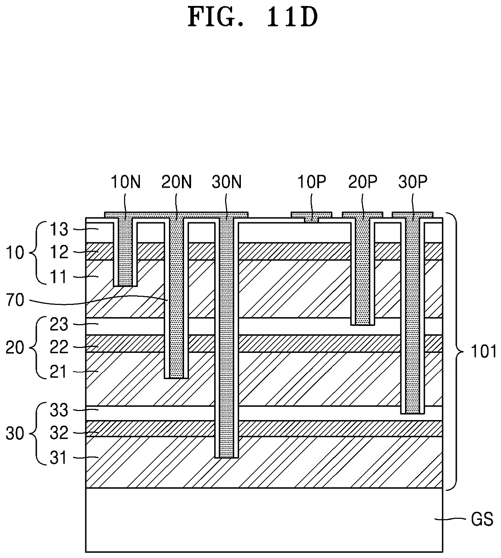

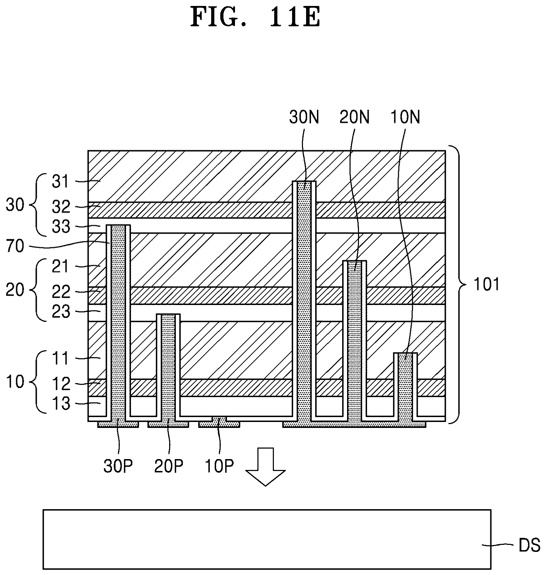

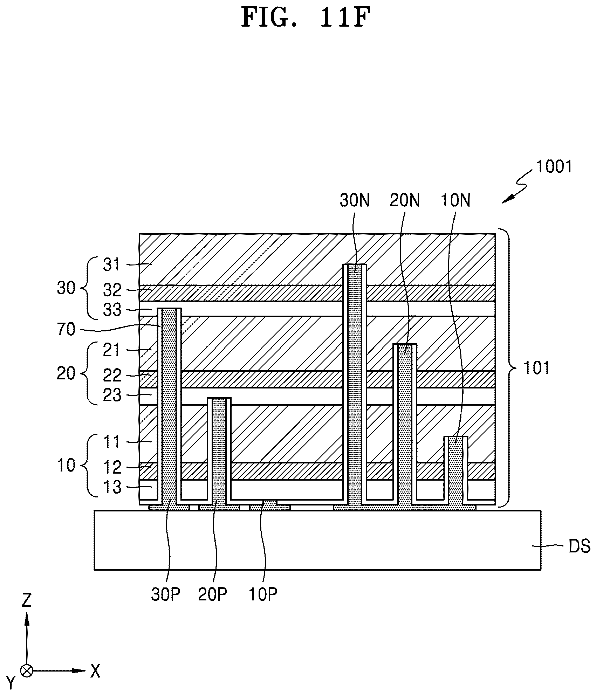

FIGS. 11A, 11B, 11C, 11D, 11E and 11F are diagrams illustrating a method of manufacturing a display apparatus according to an embodiment.

Referring to FIG. 11A, on a growth substrate GS, an epitaxy structure including a third light-emitting structure 30, a second light-emitting structure 20, and a first light-emitting structure 10 which are sequentially stacked in a vertical direction may be provided.

As the growth substrate GS, a growth substrate for semiconductor single-crystal growth, a silicon (Si) substrate, a silicon carbide (SiC) substrate, a sapphire substrate, etc. may be used. In addition to this, a substrate including a material suitable for the growth of a light-emitting structure to be formed on the growth substrate, e.g., AlN, AlGaN, ZnO, GaAs, MgAl2O4, MgO, LiAlO2, LiGaO2, or GaN, may be used as the growth substrate GS. When necessary, a buffer layer needed for the epitaxy growth of the light-emitting structure may be provided on the surface of the growth substrate GS, and the light-emitting structure may be grown on the buffer layer.

For example, the n-type semiconductor layer 31, the active layer 32, and the p-type semiconductor layer 33 may be sequentially grown on the growth substrate GS to form the third light-emitting structure 30. The third light-emitting structure 30 may include group III-V nitride semiconductor materials. The group III-V nitride semiconductor materials may include, for example, GaN, InGaN, AlInGaN, AlGaInp, etc. In this embodiment, the third light-emitting structure 30 may include a GaN-based semiconductor material. The n-type semiconductor layer 31 may be an n-GaN layer doped with an n-type impurity such as Si, Ge, Se, Te, etc. The active layer 32 may be a layer emitting light by electron-hole recombination and may have a single quantum well structure or a multi quantum well structure. For example, an quantum well layer and a barrier layer may be formed in pair, e.g., InGaN/GaN, InGaN/InGaN, InGaN/AlGaN, or InGaN/InAlGaN, to form the quantum well structure, and the bandgap energy may be controlled according to an In composition ratio of a material layer including In to adjust an emission wavelength band. The p-type semiconductor layer 33 may be a p-GaN layer doped with a p-type impurity such as Mg, Zn, Be, etc.

On the third light-emitting structure 30, the second light-emitting structure 20 including the n-type semiconductor layer 21, the active layer 22, and the p-type semiconductor layer 23 may be formed, and on the second light-emitting structure 20, the first light-emitting structure 10 including the n-type semiconductor layer 11, the active layer 12, and the p-type semiconductor layer 13 may be formed. The description of the third light-emitting structure 30 may be applied to the second light-emitting structure 20 and the first light-emitting structure 10.

The first light-emitting structure 10, the second light-emitting structure 20, and the third light-emitting structure 30 may be formed by hydride vapor phase epitaxy (HVPE), molecular beam epitaxy (MBE), metal organic vapor phase epitaxy (MOVPE), metal organic chemical vapor deposition (MOCVD), other known methods, or a combination thereof.

The third light-emitting structure 30 may emit blue light, the second light-emitting structure 20 may emit green light, and the first light-emitting structure 10 may emit red light. As illustrated in the drawings, a light-emitting structure forming light of a short wavelength may be formed on the growth substrate GS prior to a light-emitting structure forming light of a long wavelength. Such manufacturing order may be for first forming the third light-emitting structure 30 having a highest process temperature, forming the second light-emitting structure 20 having a next highest process temperature, and the forming the first light-emitting structure 10. By setting the manufacturing order of the first light-emitting structure 10, the second light-emitting structure 20, and the third light-emitting structure 30 which having different In contents from each other, as described above, exposure of the first light-emitting structure 10 having the highest In content to a high-temperature process may be minimized such that damage of In having a relatively low melting point is reduced. However, this is only an example, and the manufacturing order is not limited to the foregoing.

Then, a passivation layer 71 may be formed by depositing a dielectric material on the first light-emitting structure 10. The dielectric material may include, for example, SiO₂, TiO2, Si3N4, AlOx, AlOxNy, Ta2O5, TiN, AlN, ZrO2, TiAlN, TiSiN, HfOx, or various combinations thereof. In this embodiment, the passivation layer 71 may include SiO₂, which is a transparent dielectric material. For example, the passivation layer 71 may be formed by atomic layer deposition (ALD), plasma enhanced atomic layer deposition (PEALD), chemical vapor deposition (CVD), plasma enhanced chemical vapor deposition (PECVD), physical vapor deposition (PVD), other known methods, or a combination thereof.

Referring to FIG. 11B, by etching the passivation layer 71 and the epitaxy structure, via holes 10NH, 20HN, and 30NH exposing the n-type semiconductor layers 11, 21, and 31 and via holes 10PH, 20PH, and 30PH exposing the p-type semiconductor layers 13, 23, and 33 may be formed. This process may be performed by, for example, a dry etching process. The dry etching process may use, for example, inductively-coupled plasma (ICP). As these holes reduce active areas generating light in the first light-emitting structure 10, the second light-emitting structure 20, and the third light-emitting structure 30, the width thereof may be small. For example, the width of the holes may be 1 µm or less or 0.5 µm or less.

Referring to FIG. 11C, by depositing a dielectric material such as SiO2 on the inner walls of the via holes 10NH, 20NH, and 30NH and the via holes 20PH and 30PH, a passivation layer 72 may be formed. The passivation layer 72 may include the same material as the passivation layer 71 and may be formed by a method described above, such as the atomic layer deposition process, etc. Hereinafter, the passivation layer 72 and the passivation layer 71 may be collectively referred to as the passivation layer 70.

When necessary, a recover process may be performed on the p-type semiconductor layers 13, 23, and 33 damaged during the process of forming the holes described above, for example, the plasma etching process. For example, a p-type dopant may be additionally provided to the exposed p-type semiconductor layers 13, 23, and 33, or a p-type semiconductor material may be additionally provided.

Referring to FIG. 11D, the n-electrodes 10N, 20N, and 30N may be formed by depositing and filling the electrode material inside the via holes 10NH, 20NH, and 30NH, and the p-electrodes 10P, 20P, and 30P may be formed by depositing the electrode material inside the via holes 10PH, 20PH, and 30PH. As illustrated in the drawings, one ends of the n-electrodes 10N, 20N, and 30N may be connected to each other to form a common electrode. The electrode material may include, for example, Al, Ti, Pt, Ag, Au, Pd, TiW, or various combinations thereof. The electrode material may include a transparent electrode material, for example, ITO. This process may be formed by ALD, PEALD, CVD, PECVD, PVD, other known methods, or a combination thereof. Although the drawings illustrate a structure in which one light-emitting device chip 101 is formed on the growth substrate GS, a plurality of light-emitting device chips 101 may be formed on the growth substrate GS.

Referring to FIG. 11E, the growth substrate GS may be removed, and the light-emitting device chip 101 may be transferred on the display substrate DS.

The display substrate DS may include a driving circuit layer for driving the display apparatus, and such driving circuit layer may be formed on the substrate. The substrate may include an insulating material such as glass, organic polymer, crystal, etc. or may include a material having flexibility to facilitate bending or folding. The driving circuit layer may include transistors electrically connected to the p-electrodes 10P, 20P, and 30P included in the light-emitting device chip 101 and may further include a driving voltage line, a scan driving unit, a data driving unit, a process, etc.

The process of transferring the light-emitting device chip 101 on the display substrate DS is not specifically limited, and various methods may be used. For example, a method using a stamp, a method using a laser, a fluid self-alignment method, etc. may be used.

Referring to FIG. 11F, the display apparatus 1001 in which the light-emitting device chip 101 is arranged on the display substrate DS may be provided.

The method of manufacturing the display apparatus described above may be described by the method of manufacturing the display apparatus 1001 described in relation to FIG. 3.

According to another manufacturing method, for example, in the structure of FIG. 10A, by removing the growth substrate GS and forming a plurality of holes from a surface of the third light-emitting structure 30, the display apparatus 1002 having the structure described in relation to FIG. 4 may be manufactured.

According to another manufacturing method, for example, in the structure of FIG. 10A, by forming some holes from the surface of the first light-emitting structure 10 and forming the other holes and the electrodes from the surface of the third light-emitting structure 30, the display apparatus 1003 having the structure described in relation to FIG. 5 may be manufactured.

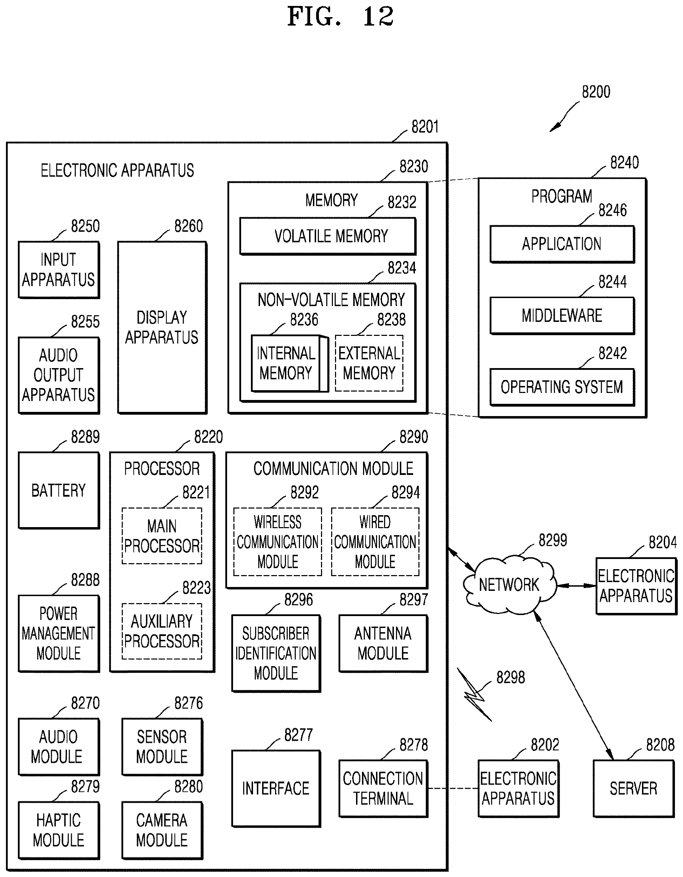

FIG. 12 is a block diagram illustrating an example of an electronic apparatus including a display according to an embodiment. Referring to FIG. 12, an electronic apparatus 8201 may be provided in a network environment 8200. **In** the network environment 8200, the electronic apparatus 8201 may communicate with another electronic apparatus 8202 through a first network 8298 (a short-range wireless communication network, etc.) or communicate with another electronic apparatus 8204 and/or a server 8208 through a second network 8299 (a long-distance wireless communication network, etc.). The electronic apparatus 8201 may communicate with the electronic apparatus 8204 through the server 8208. The electronic apparatus 8201 may include a processor 8220, a memory 8230, an input apparatus 8250, an audio output apparatus 8255, a display apparatus 8260, an audio module 8270, a sensor module 8276, an interface 8277, a haptic module 8279, a camera module 8280, a power management module 8288, a battery 8289, a communication module 8290, a subscriber identification module 8296, and/or an antenna module 8297. **In** the electronic apparatus 8201, some of constituent elements may be omitted or other constituent elements may be added. Some of the foregoing components may be implemented as a single integrated circuit. For example, the sensor module 8276 (a fingerprint sensor, an iris sensor, an illuminance sensor, and the like) may be implemented by being embedded in the display apparatus 8260 (a display, and the like).

The processor 8220 may control one or a plurality of other constituent elements (hardware and software constituent elements, and the like) of the electronic apparatus 8201 connected to the processor 8220 by executing software (a program 8240, and the like), and perform various data processing or calculations. As part of the data processing or calculations, the processor 8220 may load, in a volatile memory 8232, commands and/or data received from other constituent elements (the sensor module 8276, the communication module 8290, and the like), process the command and/or data stored in the volatile memory 8232, and store result data in a non-volatile memory 8234. The processor 8220 may include a main processor 8221 (a central processing unit, an application processor, and the like) and an auxiliary processor 8223 (a graphics processing unit, an image signal processor, a sensor hub processor, a communication processor, and the like) that is operable independently of or together with the main processor 8221. The auxiliary processor 8223 may use less power than the main processor 8221 and may perform a specialized function.

Instead of the main processor 8221 when the main processor 8221 is in an inactive state (sleep state), or with the main processor 8221 when the main processor 8221 is in an active state (application execution state), the auxiliary processor 8223 may control functions and/or states related to some constituent elements (the display apparatus 8260, the sensor module 8276, the communication module 8290, and the like) of the constituent elements of the electronic apparatus 8201. The auxiliary processor 8223 (an image signal processor, a communication processor, and the like) may be implemented as a part of functionally related other constituent elements (the camera module 8280, the communication module 8290, and the like).

The memory 8230 may store various data required by components of the electronic apparatus 8201 (such as the processor 8220, the sensor module 8276, etc.). The data may include, for example, software (the program 8240, and the like) and input data and/or output data about commands related thereto. The memory 8230 may include the volatile memory 8232 and/or the non-volatile memory 8234.

The program 8240 may be stored in the memory 8230 as software, and may include an operating system 8242, middleware 8244, and/or an application 8246.

The input apparatus 8250 may receive commands and/or data to be used for constituent elements (the processor 8220, and the like) of the electronic apparatus 8201, from the outside (a user, and the like) of the electronic apparatus 8201. The input apparatus 8250 may include a remote controller, a microphone, a mouse, a keyboard, and/or a digital pen (a stylus pen, and the like).

The audio output apparatus 8255 may output an audio signal to the outside of the electronic apparatus 8201. The audio output apparatus 8255 may include a speaker and/or a receiver. The speaker may be used for general purposes such as multimedia play or playback, and the receiver may be used to receive incoming calls. The receiver may be integrated as a part of the speaker or implemented independently as a separate apparatus.

The display apparatus 8260 may visually provide information to the outside of the electronic apparatus 8201. The display apparatus 8260 may include a display, a hologram apparatus, or a projector, and a control circuit to control a corresponding apparatus. The display apparatus 8260 may include any one of the display apparatuses 1000 to 1006 described above or a display apparatus modified therefrom. The display apparatus 8260 may include a touch circuitry set to detect a touch and/or a sensor circuit (a pressure sensor, and the like) set to measure the strength of a force generated by the touch.

The audio module 8270 may convert sound into electrical signals or reversely electrical signals into sound. The audio module 8270 may obtain sound through the input apparatus 8250, or output sound through a speaker and/or a headphone of another electronic apparatus (the electronic apparatus 8202, and the like) connected to the audio output apparatus 8255 and/or the electronic apparatus 8201 in a wired or wireless manner.

The sensor module 8276 may detect an operation state (power, temperature, and the like) of the electronic apparatus 8201, or an external environment state (a user state, and the like), and generate an electrical signal and/or a data value corresponding to a detected state. The sensor module 8276 may include a gesture sensor, a gyro sensor, a barometric pressure sensor, a magnetic sensor, an acceleration sensor, a grip sensor, a proximity sensor, a color sensor, an **IR** sensor, a biometric sensor, a temperature sensor, a humidity sensor, and/or an illuminance sensor.

The interface 8277 may support one or more specified protocols used for the electronic apparatus 8201 to be connected to another electronic apparatus (the electronic apparatus 8202, and the like) in a wired or wireless manner. The interface 8277 may include a high definition multimedia interface (HDMI), a universal serial bus (USB) interface, a secure digital (SD) card interface, and/or an audio interface.

A connection terminal 8278 may include a connector for the electronic apparatus 8201 to be physically connected to another electronic apparatus (the electronic apparatus 8202, and the like). The connection terminal 8278 may include an HDMI connector, a USB connector, an SD card connector, and/or an audio connector (a headphone connector, and the like).

The haptic module 8279 may convert electrical signals into mechanical stimuli (vibrations, movements, and the like) or electrical stimuli that are perceivable by a user through tactile or motor sensations. The haptic module 8279 may include a motor, a piezoelectric apparatus, and/or an electrical stimulation apparatus.

The camera module 8280 may capture a still image and a video. The camera module 8280 may include a lens assembly including one or more lenses, image sensors, image signal processors, and/or flashes. The lens assembly included in the camera module 8280 may collect light emitted from a subject for image capturing.

The power management module 8288 may manage power supplied to the electronic apparatus 8201. The power management module 8388 may be implemented as a part of a power management integrated circuit (PMIC).

The battery 8289 may supply power to the constituent elements of the electronic apparatus 8201. The battery 8289 may include non-rechargeable primary cells, rechargeable secondary cells, and/or fuel cells.

The communication module 8290 may establish a wired communication channel and/or a wireless communication channel between the electronic apparatus 8201 and another electronic apparatus (the electronic apparatus 8202, the electronic apparatus 8204, the server 8208, and the like), and support a communication through an established communication channel. The communication module 8290 may be operated independent of the processor 8220 (the application processor, and the like), and may include one or more communication processors supporting a wired communication and/or a wireless communication. The communication module 8290 may include a wireless communication module 8292 (a cellular communication module, a short-range wireless communication module, a global navigation satellite system (GNSS) communication module, and the like), and/or a wired communication module 8294 (a local area network (LAN) communication module, a power line communication module, and the like). Among the above communication modules, a corresponding communication module may communicate with another electronic apparatus through the first network 8298 (a short-range communication network such as Bluetooth, WiFi Direct, or infrared data association (IrDA)) or the second network 8299 (a long-range communication network such as a cellular network, the Internet, or a computer network (LAN, wide area network (WAN), and the like)). Such various types of communication modules may be integrated into one component (e.g., a single chip, etc.), or may be implemented as a plurality of separate components (e.g., multiple chips). The wireless communication module 8292 may verify and authenticate the electronic apparatus 8201 in a communication network such as the first network 8298 and/or the second network 8299 by using subscriber information (an international mobile subscriber identifier (IMSI), and the like) stored in the subscriber identification module 8296.

The antenna module 8297 may transmit signals and/or power to the outside (another electronic apparatus, and the like) or receive signals and/or power from the outside. The antenna may comprise a radiator consisting of conductive patterns formed on a substrate (e.g., a printed circuit board (PCB), etc.) The antenna module 8297 may include one or a plurality of antennas. When the antenna module 8297 includes a plurality of antennas, the communication module 8290 may select, from among the antennas, an appropriate antenna for a communication method used in a communication network such as the first network 8298 and/or the second network 8299. Signals and/or power may be transmitted or received between the communication module 8290 and another electronic apparatus through the selected antenna. Other parts (a radio frequency integrated circuit (RFIC), and the like) than the antenna may be included as a part of the antenna module 8297.

Some of the components may be connected and exchange signals (e.g., commands, data, etc.) with each other through communication methods among peripheral apparatuses (e.g., a bus, general purpose input and output (GPIO), serial peripheral interphase (SPI), mobile industry processor interface (MIPI), etc.)

The command or data may be transmitted or received between the electronic apparatus 8201 and the external electronic apparatus 8204 through the server 8208 connected to the second network 8299. The electronic apparatuses 8202 and 8204 may be of a type that is the same as or different from the electronic apparatus 8201. All or a part of operations executed in the electronic apparatus 8201 may be executed in one or more electronic apparatuses (8202, 8204, and 8208). For example, when the electronic apparatus 8201 needs to perform a function or service, the electronic apparatus 8201 may request one or more electronic apparatuses to perform part of the whole of the function or service, instead of performing the function or service. The one or more electronic apparatuses receiving the request may perform additional function or service related to the request, and transmit a result of the performance to the electronic apparatus 8201. To this end, cloud computing, distributed computing, and/or client-server computing technologies may be used.

The electronic apparatus 8201 may be applied to various apparatuses. Various components of the electronic apparatus 8201 may be properly modified according to a function of the apparatus, and other components suitable for performing the function of the apparatus may be further added. Hereinafter, application examples of the electronic apparatus 8201 are described.

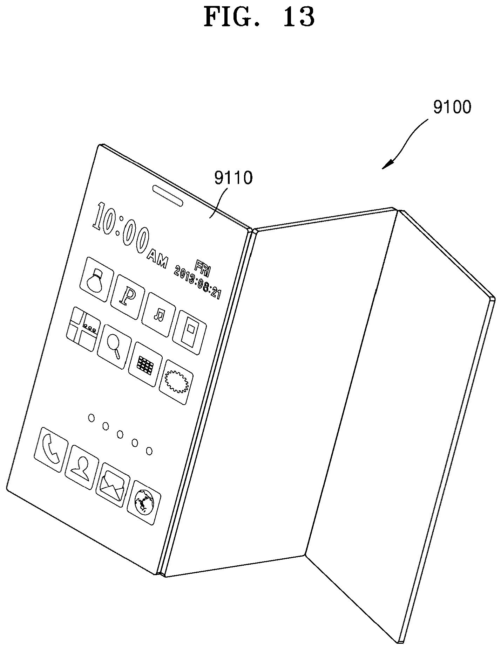

FIG. 13 is a diagram illustrating an example of a mobile apparatus as an application example of the electronic apparatus according to an embodiment. A mobile apparatus 9100 may include a display apparatus 9110. The display apparatus 9110 may include any one of the display apparatuses 1000 to 1006 described above or a display apparatus modified therefrom. The display apparatus 9110 may have a foldable structure, for example, a multi-foldable structure.

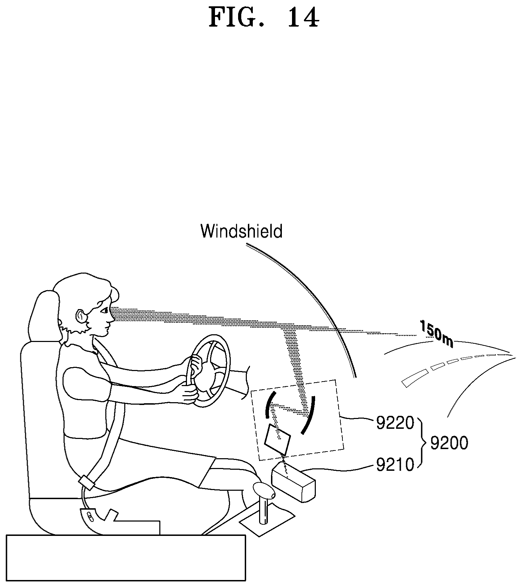

FIG. 14 is a diagram illustrating an example of a head-up display apparatus for vehicles as an application example of the electronic apparatus according to an embodiment. The head-up display apparatus 9200 for vehicles may include a display 9210 provided in an area of a vehicle and an optical path change member 9220 configured to change an optical path such that a driver can see an image generated at the display 9210. The display 9210 may include any one of the display apparatuses 1000 to 1006 described above or a display apparatus modified therefrom.

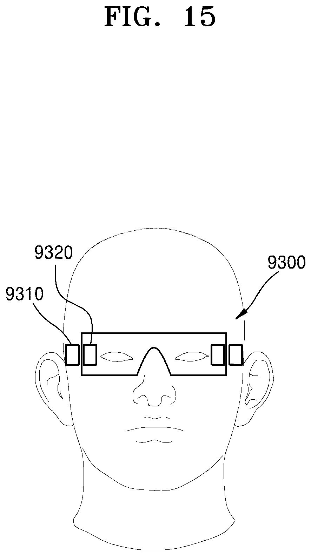

FIG. 15 is a diagram illustrating an example of augmented reality glasses or virtual reality glasses as an application example of the electronic apparatus according to an embodiment. Augmented reality glasses (or virtual reality glasses) 9300 may include a projection system 9310 configured to form an image and a guide element 9320 configured to guide the image from the projection system 9310 to user's eyes. The projection system 9310 may include any one of the display apparatuses 1000 to 1006 described above or a display apparatus modified therefrom.

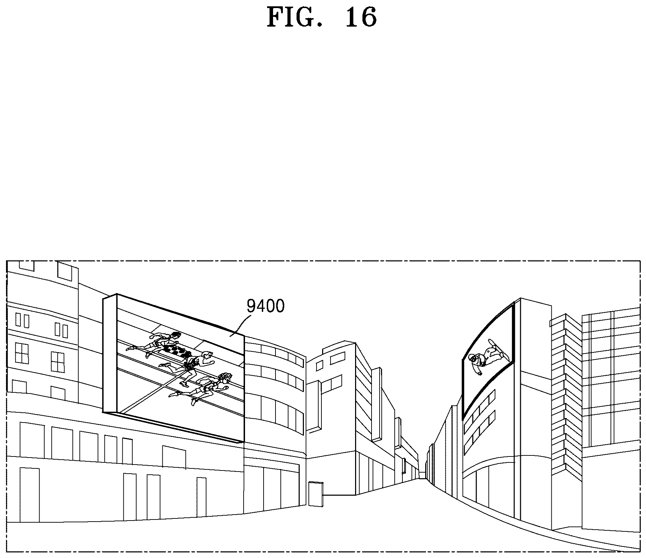

FIG. 16 is a diagram illustrating an example of a large-scale signage as an application example of the electronic apparatus according to an embodiment. A signage 9400 may be used in outdoor advertising using a digital information display, and may control contents, etc. of an advertisement through a network. The signage 9400 may be implemented from any one of the display apparatuses 1000 to 1006 described above or a display apparatus modified therefrom.

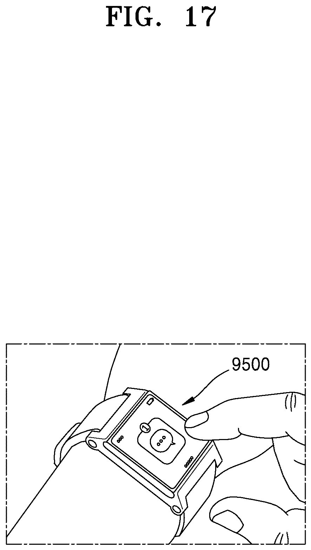

FIG. 17 is a diagram illustrating an example of a wearable display as an application example of the electronic apparatus according to an embodiment. A wearable display 9500 may be implemented from any one of the display apparatuses 1000 to 1006 described above or a display apparatus modified therefrom.

In addition to the foregoing, the light-emitting device according to an embodiment or a display including the light-emitting device may be applied to various products such as a rollable television (TV), a stretchable display, etc.

As the display apparatus described above includes the light-emitting device chip generated by the monolithic structure in which R, G, and B lights are stacked vertically, the emission efficiency thereof may increase.

By using such light-emitting device chip, the convenience of the manufacturing process of the display apparatus may be improved.

Each of the embodiments provided in the above description is not excluded from being associated with one or more features of another example or another embodiment also provided herein or not provided herein but consistent with the disclosure.

While the disclosure has been particularly shown and described with reference to embodiments thereof, it will be understood that various changes in form and details may be made therein without departing from the scope of the appended claims.

## Claims

1. A display apparatus, comprising:
a display substrate comprising a plurality of pixel areas; and
a plurality of light-emitting device chips arranged on the display substrate and respectively corresponding to the plurality of pixel areas,
wherein each of the plurality of light-emitting device chips comprises a stacked structure in which a first light-emitting structure, a second light-emitting structure, and a third light-emitting structure are stacked in a first direction on the display substrate, and
wherein the first light-emitting structure, the second light-emitting structure, and the third light-emitting structure are configured to generate light of mutually different colors.

2. The display apparatus of claim **1,** wherein each of the first light-emitting structure, the second light-emitting structure, and the third light-emitting structure comprises a p-type semiconductor layer, an active layer, and an n-type semiconductor layer, and
wherein each of the plurality of light-emitting device chips further comprises:
a first n-electrode and a first p-electrode respectively contacting the n-type semiconductor layer of the first light-emitting structure and the p-type semiconductor layer of the first light-emitting structure;
a second n-electrode and a second p-electrode respectively contacting the n-type semiconductor layer of the second light-emitting structure and the p-type semiconductor layer of the second light-emitting structure; and
a third n-electrode and a third p-electrode respectively contacting the n-type semiconductor layer of the third light-emitting structure and the p-type semiconductor layer of the third light-emitting structure.

3. The display apparatus of claim 2, wherein the first light-emitting structure is configured to generate red light, wherein the second light-emitting structure is configured to generate green light, and wherein the third light-emitting structure is configured to generate blue light.

4. The display apparatus of claim 3, wherein the second light-emitting structure is stacked on the first light-emitting structure, and wherein the third light-emitting structure is stacked on the second light-emitting structure.

5. The display apparatus of claim 4, wherein the first n-electrode, the second n-electrode, the third n-electrode, the first p-electrode, the second p-electrode, and the third p-electrode are exposed at a lower surface of the first light-emitting structure in the first direction.

6. The display apparatus of claim 5, wherein the first n-electrode comprises a conductive via extending from the lower surface of the first light-emitting structure, penetrating an inside of each of the plurality of light-emitting device chips and contacting the n-type semiconductor layer of the first light-emitting structure,
wherein the second n-electrode comprises a conductive via extending from the lower surface of the first light-emitting structure, penetrating the inside of each of the plurality of light-emitting device chips and contacting the n-type semiconductor layer of the second light-emitting structure, and
wherein the third n-electrode comprises a conductive via extending from the lower surface of the first light-emitting structure, penetrating the inside of each of the plurality of light-emitting device chips and contacting the n-type semiconductor layer of the third light-emitting structure,
wherein, preferably, the first n-electrode, the second n-electrode, and the third n-electrode are connected to each other on the lower surface of the first light-emitting structure and form a common electrode.

7. The display apparatus of claim 5, wherein the second p-electrode comprises a conductive via extending from the lower surface of the first light-emitting structure, penetrating an inside of each of the plurality of light-emitting device chips and contacting the p-type semiconductor layer of the second light-emitting structure, and
wherein the third p-electrode comprises a conductive via extending from the lower surface of the first light-emitting structure, penetrating the inside of each of the plurality of light-emitting device chips and contacting the p-type semiconductor layer of the third light-emitting structure.

8. The display apparatus of claim 4, wherein each of the plurality of light-emitting device chips comprises a first surface facing the display substrate and a second surface opposite the first surface in the first direction,
wherein the first p-electrode, the second p-electrode, and the third p-electrode are exposed on the first surface, and
wherein the first n-electrode, the second n-electrode, and the third n-electrode are exposed on the second surface,
wherein, preferably:
the first n-electrode comprises a conductive via extending from the second surface, penetrating an inside of each of the plurality of light-emitting device chips and contacting the n-type semiconductor layer of the first light-emitting structure,
the second n-electrode comprises a conductive via extending from the second surface, penetrating the inside of each of the plurality of light-emitting device chips and contacting the n-type semiconductor layer of the second light-emitting structure,
the second p-electrode comprises a conductive via extending from the first surface, penetrating the inside of each of the plurality of light-emitting device chips and contacting the p-type semiconductor layer of the second light-emitting structure, and
the third p-electrode comprises a conductive via extending from the first surface, penetrating the inside of each of the plurality of light-emitting device chips and contacting the p-type semiconductor layer of the third light-emitting structure.

9. The display apparatus of claim 3, wherein the second light-emitting structure is stacked on the third light-emitting structure, and wherein the first light-emitting structure is stacked on the second light-emitting structure,
wherein, preferably, the first n-electrode, the second n-electrode, the third n-electrode, the first p-electrode, the second p-electrode, and the third p-electrode are exposed on a lower surface of the third light-emitting structure in the first direction.

10. The display apparatus of any of the claims 3-9, wherein the first n-electrode, the second n-electrode, the third n-electrode, the first p-electrode, the second p-electrode, and the third p-electrode form a red light-emitting area, a green light-emitting area, and a blue light-emitting area on a surface that is perpendicular to the first direction.

11. The display apparatus of claim 10, wherein the first n-electrode, the second n-electrode, the third n-electrode, the first p-electrode, the second p-electrode, and the third p-electrode are configured such that the red light-emitting area is greatest in size among the red light-emitting area, the green light-emitting area, and the blue light-emitting area,
wherein, preferably:
the first n-electrode, the second n-electrode, the third n-electrode, the first p-electrode, the second p-electrode, and the third p-electrode are configured such that, among the red light-emitting area, the green light-emitting area, and the blue light-emitting area, the red light-emitting area is greatest in size and the blue light-emitting area is smallest in size; and/or
the blue light-emitting area is spaced apart from the green light-emitting area in a second direction, and the blue light-emitting area is spaced apart from the red light-emitting area in a third direction that is different from the second direction.

12. The display apparatus of any of the previous claims, wherein each of the plurality of pixel areas comprises three subpixel areas, wherein each of the plurality of light-emitting device chips is arranged over the respective three subpixel areas.

13. A method of manufacturing a display apparatus, the method comprising:
forming an epitaxy structure by sequentially stacking, on a growth substrate, a third light-emitting structure, a second light-emitting structure, and a first light-emitting structure, each of the third light-emitting structure, the second light-emitting structure, and the first light-emitting structure comprising a p-type semiconductor layer, an active layer, and an n-type semiconductor layer and each of the third light-emitting structure, the second light-emitting structure, and the first light-emitting structure being configured to generate light of different wavelengths from each other;
forming a light-emitting device chip by forming n-electrodes respectively contacting the n-type semiconductor layers of the first light-emitting structure, the second light-emitting structure, and the third light-emitting structure and forming p-electrodes respectively contacting the p-type semiconductor layers of the first light-emitting structure, the second light-emitting structure, and the third light-emitting structure; and
transferring the light-emitting device chip on a display substrate.

14. The method of claim 13, wherein the third light-emitting structure is configured to generate blue light, wherein the second light-emitting structure is configured to generate green light, and wherein the first light-emitting structure is configured to generate red light.

15. The method of claim 13 or 14, wherein the n-electrodes and the p-electrodes are exposed on a same surface of the epitaxy structure; or
wherein the n-electrodes are exposed on a first surface of the epitaxy structure, and wherein the p-electrodes are exposed on a second surface of the epitaxy structure.
